# EUROPÄISCHE PATENTSCHRIFT

(11) **EP 2 109 186 B1**
(45) Veröffentlichungstag und Bekanntmachung des Hinweises auf die Patenterteilung: **23.06.2010**
(21) Anmeldenummer: 08006993.3
(22) Anmeldetag: 08.04.2008
(51) Int. Cl.: H01R 4/18, H01R 43/048, H01R 43/24

(54) **Verfahren zur Herstellung einer elektrischen Verbindung zwischen einer Stromschiene und einer Leiterplatte**
Method for producing an electrical connection between an electrified rail and a circuit board
Procédé de fabrication d'une connexion électrique entre un rail conducteur et une circuit imprimé

(43) Veröffentlichungstag der Anmeldung: 14.10.2009
(73) Patentinhaber: Delphi Technologies, Inc., Troy, Michigan 48007 (US)
(72) Erfinder: Wirths, Jochen, 51545 Waldbroel (DE); Kortwig, Carsten, 42929 Wermelskirchen (DE)
(74) Vertreter: Denton, Michael John

(56) Entgegenhaltungen:
- EP-A- 0 735 628
- AT-B- 298 593
- DE-A1- 4 222 651
- DE-U1- 7 800 641
- JP-A- 2004 022 274
- US-A- 3 410 952

## Beschreibung

Die vorliegende Erfindung betrifft ein Verfahren zur Herstellung einer elektrischen Verbindung zwischen einer Stromschiene und einer Leiterplatte , welches gemäß dem Oberbegriff des Anspruchs 1 ausgebildet ist. Ein derartiges Verfahren wird beispielsweise in EP 0 735 628 A2 beschrieben.

In elektrischen Baugruppen zum Schalten höherer Ströme ist es häufig erforderlich, Bauelemente, wie beispielsweise Widerstände, Mikrochips oder Dioden, mit Stromführungsschienen aus Metall, wie beispielsweise Kupfer oder einer Kupferlegierung zu verbinden. Zur Ansteuerung dieser auf einer Stromführungsschiene angeordneten Bauelemente kann es dabei erforderlich werden, die Stromschiene mit einer Steuerungs-Leiterplatte zu verbinden. Die Verbindung zwischen der Leiterplatte und der Stromschiene kann dabei beispielsweise durch Drahtbonden oder über eine händisch mit der Stromschiene und der Leiterplatte verlötete Kabelverbindung erfolgen.

Sowohl das Drahtbonden als auch das Herstellen einer händisch verlöteten Kabelverbindung zwischen der Stromschiene und der Leiterplatte ist jedoch mit verhältnismäßig hohen Kosten verbunden, weshalb es wünschenswert wäre, eine elektrische Verbindung zwischen einer Stromschiene und einer Leiterplatte mit einfacheren und weniger kostenintensiven Mitteln herstellen zu können.

Zur Herstellung einer lötfreien elektrischen Verbindung mit einer Leiterplatte ist die so genannte Einpress- bzw. Press-Fit-Verbindungstechnologie bekannt. Bei dieser Technik wird ein so genannter Einpressstift in ein metallisiertes bzw. durchkontaktiertes Loch einer Leiterplatte eingepresst, wobei die Diagonale des Stiftquerschnitts größer als der Durchmesser des Lochs in der Leiterplatine ist. Vorzugsweise kann dabei der Einpressstift an einem Ende elastisch federnd ausgebildet sein, so dass beim Einpressen des Stifts in das Loch die dabei entstehende Überpressung durch eine Verformung der Leiterplatte im Bereich des Lochs und/oder durch eine Verformung des Stifts kompensiert wird. Durch die elastische Verformung des Stifts und/oder der Leiterplatte im Bereich des Lochs wird dabei eine kraftschlüssige und infolge der Verformung zumindest einer der Komponenten gasdichte Verbindung hergestellt.

Zwar ließe sich mit einem elastisch federnden Einpressstift möglicherweise auch eine elektrische Verbindung mit einer Stromschiene herstellen; da derartige Stromschienen jedoch aufgrund der relativ hohen Ströme als verhältnismäßig massive Metallplatten ausgebildet sind, können sich diese beim Einpressen eines Einpressstifts nicht verformen, was dazu führt, dass eine so hergestellte Verbindung nicht gasdicht und somit auch nicht ausreichend korrosionsbeständig ist.

Der Erfindung liegt daher die Aufgabe zugrunde, eine möglichst einfach und kostengünstig zu realisierende Verbindungstechnik zu schaffen, mit der eine elektrisch leitende Verbindung zwischen einer Leiterplatte und einer Stromschiene hergestellt werden kann, und welche insbesondere in Bezug auf Korrosion unanfällig ist.

Diese Aufgabe wird mit einem Verbindungsverfahren gelöst, welches die Merkmale des Anspruchs 1 aufweist.

Bei dem erfindungsgemäßen Verfahren zur Herstellung einer elektrischen Verbindung zwischen einer Stromschiene und einer Leiterplatte bedient man sich einerseits der Einpress- bzw. Press-Fit-Verbindungstechnologie, um eine kraftschlüssige Press-Fit-Verbindung zwischen der Leiterplatte und einem ersten Ende eines Einpressstifts herzustellen. Im Unterschied dazu wird erfindungsgemäß die Verbindung zwischen dem Einpressstift und der Stromschiene jedoch nicht durch eine kraftschlüssige sondern durch eine formschlüssige Verbindung dessen zweiten Endes und der Stromschiene hergestellt.

Der Formschluss zwischen dem Einpressstift und der Stromschiene kann dabei erzeugt werden, indem durch Krafteinwirkung auf die Stromschiene dieselbe plastisch verformt wird, so dass diese mit dem Einpressstift formschlüssig in Eingriff steht bzw. durch die Krafteinwirkung in Eingriff gebracht wird. Durch die plastische Umformung der Stromschiene beginnt dabei das Metall, aus dem die Stromschiene gefertigt ist, zu fließen, so dass der Einpressstift gasdicht von der Stromschiene aufgenommen wird. Insbesondere kehrt dabei aufgrund der plastischen Umformung der Stromschiene der plastisch umgeformte Bereich derselben nicht in seinen Ausgangszustand zurück, wodurch die Schnittstelle zwischen dem Einpressstift und der Stromschiene dauerhaft gasdicht und somit auf Dauer korrosionsbeständig ist.

Bevorzugte Ausführungsformen der vorliegenden Erfindung ergeben sich aus den Unteransprüchen, der folgenden Beschreibung sowie den Zeichnungen.

Zwar wäre es möglich, die Stromschiene im Bereich des Lochs, in das das zweite Ende des Einpressstifts eingeführt wird, so umzuformen, dass durch die in dem umgeformten Material der Stromschiene wirkenden Kräfte an dem zweiten Ende des Einpressstifts eine Einquetschung erzeugt wird, über die dann der Einpressstift verzahnt mit der Stromschiene in Eingriff steht.

Da jedoch verhältnismäßig große Umformkräfte benötigt werden, um eine derartige Einquetschung an dem Einpressstift zu erzeugen, ist es gemäß einer bevorzugten Ausführungsform vorgesehen, dass an dem zweiten Ende des Einpressstifts zur Unterstützung der Herstellung der Formschlussverbindurig zumindest eine Hinterschneidung vorgesehen wird, in die das umgeformte Material beim Umformen eindringen bzw. hinein fließen kann. Diese Ausführungsform ermöglicht nicht nur eine Reduzierung der Umformkräfte; vielmehr ist eine auf diese Weise hergestellte formschlüssige Verbindung besonders gasdicht und damit korrosionsbeständig. Darüber hinaus ist eine auf diese Weise hergestellte formschlüssige Verbindung auch besonders unempfindlich in Bezug auf Vibrationen, wie sie beispielsweise während des Betriebs eines Kraftfahrzeugs auftreten können, so dass sich der Einpressstift nicht von der Stromschiene lösen kann. Die so hergestellte Formschlussverbindung zwischen dem Einpressstift und der Stromschiene ist also nicht nur gasdicht, sondern darüber hinaus auch schwingungsunempfindlich, so dass sich die erfindungsgemäße Verbindungstechnik insbesondere auch für die Verwendung im Bereich der Automobiltechnik eignet.

Die Zuverlässigkeit der Verbindung zwischen der Stromschiene und dem zweiten Ende des Einpressstifts kann ferner insbesondere dadurch gesteigert werden, indem an dem zweiten Ende des Einpressstifts mehrere in Längsrichtung des Einpressstifts zueinander beabstandete Hinterschneidungen vorgesehen werden. Darüber hinaus eignet sich ein Einpressstift mit mehreren in Längsrichtung zueinander beabstandeten Hinterschneidungen zur Verwendung bei unterschiedlich dicken Stromschienen, da dadurch, dass mehrere Hinterschneidungen in Längsrichtung des Einpressstifts aufeinander folgen, sichergestellt ist, dass selbst bei einer verhältnismäßig dünnen Stromschiene zumindest eine Hinterschneidung im Bereich des jeweiligen durchkontaktierten Lochs derselben zu liegen kommt.

Zwar wäre es möglich, das Metall der Stromschiene im Bereich um das Loch, in dem das zweite Ende des Einpressstifts angeordnet wird, dadurch in den fließfähigen Zustand zu überführen und umzuformen, dass der Bereich um das Loch durch Hitzeeinwirkung derart stark erwärmt wird, dass das Metall flüssig wird und somit in die zumindest eine Hinterschneidung am zweiten Ende des Einpressstifts eindringt. Da jedoch dieses Umformverfahren für die Serienproduktion eher nicht geeignet ist, wird gemäß einer bevorzugten Ausführungsform vorgeschlagen, zur Umformung der Stromschiene im Bereich um das Loch einen Kerbstempel zu verwenden, mit dem der Lochrand gezielt zu dem Einpressstift hin verformt werden kann.

Da zur Umformung der Stromschiene unter Verwendung eines Kerbstempels verhältnismäßig große Umformkräfte benötigt werden, ist es gemäß einer weiteren bevorzugten Ausführungsform vorgesehen, in einem ersten Schritt zunächst den bzw. die Einpressstifte formschlüssig mit der Stromschiene zu verbinden, bevor anschließend der bzw. die Einpressstifte mit ihrem ersten Ende in entsprechend durchkontaktierte Löcher einer Leiterplatte eingepresst werden. Dadurch, dass die Einpressstifte einzeln zunächst mit der Stromschiene verbunden werden, wird für die Verbindung jedes einzelnen Einpressstifts mit der Stromschiene eine nur geringere Umformkraft benötigt, als wenn alle Einpressstifte gleichzeitig in entsprechende Öffnungen der Stromschiene eingeführt und durch Umformen derselben in dem jeweiligen Loch verzahnt werden. Diese Vorgehensweise macht es jedoch erforderlich, zunächst die Einpressstifte mit der Stromschiene zu verbinden, bevor anschließend die Verbindung der Leiterplatte mit den Einpressstiften vorgenommen werden kann.

Um die Korrosionsbeständigkeit der Einpressstifte selbst zu erhöhen, können diese im Bereich zwischen ihren beiden Enden, mit denen sie mit der Leiterplatte bzw. mit einer Stromschiene verbunden werden, mit einem Isoliermaterial umhüllt sein. Alternativ hierzu wäre es ebenfalls möglich, die Einpressstifte ohne solch eine Isoliermanschette vorzuhalten und die Einpressstifte erst dann mit einem Isoliermaterial zu umhüllen, nachdem sie in der voran beschriebenen Art und Weise mit einer Stromschiene verbunden worden sind.

Im Folgenden wird nun die Erfindung rein exemplarisch und unter Bezugnahme auf die beigefügten Zeichnungen beschrieben, wobei:
- Fig. 1: eine über drei erfindungsgemäße Einpressstifte mit einer Leiterplatte unter Verwendung des erfindungsgemäßen Verfahrens verbundene Stromschiene zeigt;
- Fig. 2: das Herstellen einer Formschlussverbindung eines Einpressstifts mit einer Stromschiene veranschaulicht; und
- Fig. 3: das Umformen der Stromschiene unter Verwendung eines Kerbstempels gemäß dem Detail A der Fig. 2 veranschaulicht.

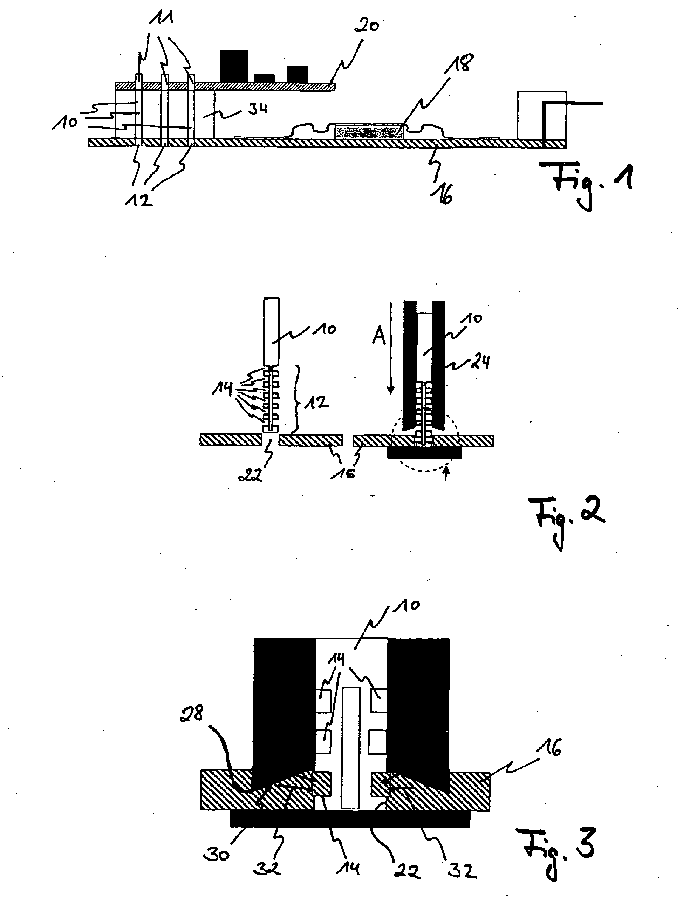

Die Fig. 1 zeigt eine Stromschiene 16, oberhalb derer eine Leiterplatte 20 angeordnet ist, welche mit der Stromschiene 16 über drei Strompfade in Form jeweils eines speziell ausgebildeten Einpressstifts 10 verbunden ist. Auf der Stromschiene 16 ist ein elektronisches Bauelement 18, wie beispielsweise ein Widerstand, eine Diode oder ein Mikrochip angeordnet, welches seinerseits von der Leiterplatine 20 bzw. dessen elektronischen Komponenten angesteuert werden kann.

Da ein elektronisches Bauelement 18 wie beispielsweise ein Widerstand, eine Diode oder ein Mikrochip verhältnismäßig viel Wärme erzeugen kann, ist das Bauelement 18 bewusst auf der Stromschiene 16 und nicht auf der Leiterplatte 20 angeordnet, da die Stromschiene 16 aufgrund ihrer metallischen Ausbildung, beispielsweise als Kupferplatte, die von dem Bauelement 18 erzeugte Wärmeenergie gut transportieren und ableiten kann.

Um das elektronische Bauteil 18 der Stromschiene 16 von der Leiterplatte 20 aus ansteuern zu können, wird die Stromschiene 16 mit der Leiterplatte 20 über die drei erfindungsgemäß ausgebildeten Einpressstifte 10 verbunden, welche jeweils ein erstes Ende 11 zur Herstellung einer kraftschlüssigen Press-Fit-Verbindung mit der Leiterplatte 20 und ein zweites Ende 12 aufweisen, welches zur Herstellung einer Formschlussverbindung mit der Stromschiene 16 ausgebildet ist. Da das Herstellen einer kraftschlüssigen Press-Fit-Verbindung eines Einpressstifts mit einer Leiterplatte grundsätzlich bekannt ist, wird im Folgenden unter Bezugnahme auf die Fig. 2 und 3 nur auf die Herstellung der Formschlussverbindung der Einpressstifte 10 mit der Stromschiene 16 eingegangen.

Wie der linken Darstellung der Fig. 2 entnommen werden kann, weist die Stromschiene 16 zur Aufnahme jedes Einpressstifts 10 ein Durchgangsloch 22 auf, wobei es sich anstelle eines Durchgangslochs 22 jedoch auch um ein Sackloch handeln kann. Jeder der Einpressstifte 10 weist im Bereich seines zweiten Endes 12 zumindest eine Hinterschneidung 14, vorzugsweise jedoch mehrere in Längsrichtung zueinander beabstandete Hinterschneidungen 14 auf, welche dazu dienen, um eine formschlüssige Verzahnung der Stromschiene 16 durch Umformen derselben mit dem zweiten Ende 12 des Einpressstifts 10 erzeugen zu können.

Hierzu wird der Einpressstift 10 mit seinem zweiten Ende 12 zunächst in das Durchgangsloch 22 der Stromschiene 16 eingeführt. Die Hinterschneidungen 14 sind dabei so dimensioniert und derart voneinander beabstandet, dass zumindest eine Hinterschneidung 14 sich in dem Durchgangsloch 22 befindet, nachdem der Einpressstift 10 mit seinem zweiten Ende 12 in das Durchgangsloch 22 eingeführt wurde (siehe rechte Darstellung der Fig. 2). Nachdem das zweite Ende des Einpressstifts 10 auf diese Weise in das Durchgangsloch 22 der Stromschiene 16 eingesteckt wurde, wird ein hohlzylindrischer Kerbstempel 24 über den Einpressstift 10 gestülpt, so dass dieser an seinem vorderen Ende im Bereich des Durchgangslochs 22 gegen die Stromschiene 16 drückt. Der Kerbstempel 24 weist dabei an seinem vorderen Ende einen trichterförmigen Bereich auf, dessen Trichterfläche 30 durch eine umlaufende Schneide 28 begrenzt wird.

Wenn der Kerbstempel 24 in Richtung des Pfeils A (rechte Darstellung der Fig. 2) gegen die Stromschiene 16 gedrückt wird, welche ihrerseits auf einer Auflage 26 aufliegt, so kerbt sich der Kerbstempel 24 mit seiner Schneide 28 voraus in das Metall der Stromschiene 16 ein, wodurch entsprechend den Pfeilen 32 (siehe Fig. 3) ein Materialfluss 32 in der Stromschiene 16 erzeugt wird, welcher in die in dem Durchgangsloch 22 befindlichen Hinterschneidungen 14 des Einpressstifts 10 fließt. Hierdurch wird eine verzahnte Formschlussverbindung zwischen dem Einpressstift 10 und der Stromschiene 16 erzeugt, welche aufgrund der plastischen Verformung des Materials der Stromschiene 16 dauerhaft gasdicht und somit korrosionsbeständig ist.

Nachdem auf diese Weise mehrere Einpressstifte 10 mit der Stromschiene 16 verbunden worden sind, kann anschließend auf die frei von der Stromschiene 16 auskragenden Einpressstifte 10 bzw. auf deren jeweiliges erste Ende 11, welches vorzugsweise federnd ausgebildet sein kann, eine Leiterplatte 20 aufgesteckt werden, wie dies in der Fig. 1 dargestellt ist.

Außerdem können die Einpressstifte 10 vor oder nach der Anbringung der Leiterplatte 20 mit einem Isoliermaterial 34 umgossen oder umspritzt werden, welches zum einen die Leiterplatte 20 gegenüber der Stromschiene abschirmt und isoliert und zum anderen nach seinem Aushärten als Tragkörper für die Leiterplatte 20 dient.

Zusätzlich zu den bereits voran beschriebenen Vorteilen bringt die vorliegende Erfindung den weiteren Vorteil mit sich, dass die so herstellbare Verbindung zwischen der Stromschiene 16 und der Leiterplatte 20 lösbar ist. So können beispielsweise zu Testzwecken die Leiterplatte 20 und die Stromschiene 16 über die lösbare Press-Fit-Verbindung der Einpressstifte 10 vorübergehend miteinander verbunden werden, um die Funktionalität der so gebildeten elektronischen Anordnung zu testen. Wenn bei diesem Test beispielsweise festgestellt wird, dass das elektronische Bauteil 18 auf der Stromschiene 16 defekt sein sollte, wohingegen jedoch die Leiterplatte 20 intakt ist, so bedarf es lediglich eines Austauschs der Stromschiene 16. Wäre hingegen die Leiterplatte 20 und die Stromschiene 16 durch Drahtbonden oder eine Kabelverbindung fest miteinander verbunden, so würde es sich um die gesamte elektronische Anordnung aus Leiterplatte 20 und Stromschiene 16 um Ausschussproduktion handeln, da gerade in der Massenproduktion das Lösen der an und für sich unlösbaren gelöteten oder drahtgebondeten Verbindung zwischen der Leiterplatte 20 und der Stromschiene 16 in wirtschaftlicher Hinsicht nicht sinnvoll ist. Mit der vorliegenden Erfindung kann somit auch der Anteil an Ausschussteilen reduziert werden, was sich insbesondere in wirtschaftlicher Hinsicht als vorteilhaft erweist.

### Bezugszeichenliste

- 10: Einpressstift
- 11: erstes Ende von 10
- 12: zweites Ende von 10
- 14: Hinterschneidungen
- 16: Stromschiene
- 18: elektronische Bauteile
- 20: Leiterplatte, PCB
- 22: Durchgangsloch
- 24: Kerbstempel
- 26: Auflage
- 28: Schneide
- 30: Trichterfläche
- 32: Materialfluss
- 34: Isoliermaterial

- A: Vorschubrichtung von 24

## Patentansprüche

1. Verfahren zur Herstellung einer elektrischen Verbindung zwischen einer Stromschiene (16) und einer Leiterplatte (20), mit den Schritten:
(i) Herstellen einer Press-fit Verbindung eines ersten Endes (11) eines Einpressstifts (10) mit der Leiterplatte (20); und
(ii) Herstellen einer Formschlussverbindung eines zweiten Endes (12) des Einpressstifts (10) mit der Stromschiene (16);
**dadurch gekennzeichnet, dass**
zur Herstellung der Formschlussverbindung das zweite Ende (12) des Einpressstifts (10) in ein Loch (22) der Stromschiene (16) eingeführt und die Stromschiene (16) im Bereich um das Loch (22) derart plastisch umgeformt wird, dass das plastisch umgeformte Material der Stromschiene (16) mit dem zweiten Ende des Einpressstifts (10) verzahnt in Eingriff steht.

2. Verfahren nach Anspruch 1,
**dadurch gekennzeichnet, dass**
dass an dem zweiten Ende des Einpressstifts (10) zur Unterstützung der Herstellung der Formschlussverbindung zumindest eine Hinterschneidung (14) vorgesehen wird, in die das umgeformte Material beim Umformen eindringt.

3. Verfahren nach zumindest einem der vorstehenden Ansprüche,
**dadurch gekennzeichnet, dass**
zur Umformung der Stromschiene (16) ein Kerbstempel (24) verwendet wird, durch den der Lochrand zu dem Einpressstift (10) hin verformt wird.

4. Verfahren nach Anspruch 1,
**dadurch gekennzeichnet, dass**
Schritt (ii) vor Schritt (i) durchgeführt wird, wobei in Schritt (ii) mehrere Einpressstifte (10) nacheinander mit der Stromschiene (16) verbunden werden.

5. Verfahren nach zumindest einem der vorstehenden Ansprüche,
**dadurch gekennzeichnet, dass**
der bzw. die Einspressstifte (10) nach Schritt (ii) mit einem Isoliermaterial (34) umhüllt werden.

## Claims

1. Method for manufacturing an electrical connection between a bus bar (16) and a printed circuit board (20), comprising the steps of
(i) establishing a press-fit connection of a first end (11) of a press fit pin (10) with the printed circuit board (20); and
(ii) establishing a form-fit connection of a second end (12) of the press fit pin (10) with the bus bar (16);
**characterized in that**
for establishing the form-fit connection the second end (12) of the press fit pin (10) is inserted into a hole (22) of the bus bar (16) and the bus bar (16) is plastically transformed in an area around the hole (22) such that the plastically transformed material of the bus bar (16) is in toothed engagement with the second end of the press fit pin (10).

2. Method according to claim 1,
**characterized in that** for support of the generation of the form-fit connection, at least one undercut (14), into which the transformed material enters when being transformed, is provided at the second end of the press fit pin (10).

3. Method according to at least one of the preceding claims,
**characterized in that** for transformation of the bus bar (16) a notch stamp (24) is used, by which the margin of the hole is transformed toward the press fit pin (10).

4. Method according to claim 1,
**characterized in that** step (ii) is performed before step (i), wherein in step (ii) a plurality of press fit pins (10) are connected successively with the bus bar (16).

5. Method according to at least one of the preceding claims,
**characterized in that** the press fit pin(s) (10) are coated with an insulating material (34) after step (ii).

## Revendications

1. Procédé pour établir une connexion électrique entre un rail électrique (16) et une plaque à circuits (20), comprenant les étapes suivantes :
(i) on réalise une liaison à la presse d'une première extrémité (11) d'une tige à presser (10) avec la carte à circuits (20) ; et
(ii) on établit une liaison à coopération de formes d'une seconde extrémité (12) de la tige à presser (10) avec le rail électrique (16) ;
**caractérisé en ce que**
pour établir la liaison à coopération de formes, la seconde extrémité (12) de la tige à presser (10) est introduite dans un trou (22) du rail électrique (16), et le rail électrique (16) est déformé dans la zone autour du trou (22) de manière plastique, de telle façon que le matériau du rail électrique (16) ayant subi une déformation plastique se trouve en engagement denté avec la seconde extrémité de la tige à presser (10).

2. Procédé selon la revendication 1,
**caractérisé en ce que**, pour aider à établir la connexion à coopération de formes, on prévoit à la seconde extrémité de la tige à presser (10) au moins une contre-dépouille (14) dans laquelle pénètre le matériau déformé lors de la déformation.

3. Procédé selon l'une au moins des revendications précédentes,
**caractérisé en ce que**, pour la déformation du rail électrique (16), on utilise un poinçon-entailleur (24), au moyen duquel la bordure du trou est déformée vers la tige à presser (10).

4. Procédé selon la revendication 1,
**caractérisé en ce que** l'étape (ii) est exécutée avant l'étape (i), et dans l'étape (ii), on relie plusieurs tiges à presser (10) les unes après les autres avec le rail électrique (16).

5. Procédé selon l'une au moins des revendications précédentes,
**caractérisé en ce que** la ou les tiges à presser (10) est/sont enveloppée(s) avec un matériau isolant (34) après l'étape (ii).
